# EUROPÄISCHE PATENTSCHRIFT

(11) **EP 0 413 984 B1**
(45) Veröffentlichungstag und Bekanntmachung des Hinweises auf die Patenterteilung: **03.11.1993**
(21) Anmeldenummer: 90114200.0
(22) Anmeldetag: 25.07.1990
(51) Int. Cl.: H01F 1/00, G11B 5/39

(54) **Magnetoresistiver Sensor**
Magneto-resistive sensor
Palpeur magnéto-résistif

(30) Priorität: 23.08.1989 DD 332029
(43) Veröffentlichungstag der Anmeldung: 27.02.1991
(73) Patentinhaber: HL PLANARTECHNIK GMBH, 44227 Dortmund (DE)
(72) Erfinder: Dettmann, Fritz, Dr.sc.nat. Dipl.-Phys., O-6902 Jena (DE); Loreit, Uwe, Dipl.-Phys., O-6530 Hermdorf (DE); Linke, Stephan, Dr.rer.nat. Dipl.-Phys., O-6908 Jena (DE); Pertsch, Peter, Dr.rer.nat. Dipl.-Phys., O-6530 Hermsdorf (DE)
(74) Vertreter: von Rohr, Hans Wilhelm, Dipl.-Phys.

(56) Entgegenhaltungen:
- EP-A- 0 152 000
- EP-A- 0 355 044
- DE-A- 2 512 525
- DE-A- 3 622 241
- US-A- 4 622 613

## Beschreibung

Die Erfindung betrifft einen magnetoresistiven Sensor mit mindestens einem magnetoresistiven Schichtstreifen nach dem Oberbegriff von Anspruch 1.

Magnetoresistive Sensoren werden zur Messung von magnetischen Feldern und deren Gradienten eingesetzt. Sie finden bei der potentialfreien Messung von Gleich- und Wechselströmen Anwendung. Sie können in Kombination mit billigen Magneten bei der empfindlichen Positions- und Winkelbestimmung sowie zur Drehgeschwindigkeitsmessung benutzt werden. Weiterhin kommen sie als funktionsbestimmendes Bestandteil elektronischer Schalt- und Regelelemente zum Einsatz. Als Haupteinsatzgebiete können die Automatisierungs- und Kfz-Technik genannt werden.

Magnetoresistive Sensoren mit magnetoresistiven Schichtstreifen, auf denen unter einem bestimmten Winkel und in gleichen Abständen Leitschichtstreifen angeordnet werden, sind seit langem bekannt (DE-OS 25 12 525). Ein wesentlicher Nachteil dieser einfachen Anordnung besteht in der Veränderung der funktionsbestimmenden Eigenschaften der magnetoresistiven Schichtstreifen durch Eindringen von Sauerstoff, insbesondere bei höheren Arbeitstemperaturen und bei notwendigerweise bei erhöhten Temperaturen ablaufenden Weiterverarbeitungsschritten der Sensorchips. Dieser Nachteil läßt sich dadurch beseitigen, daß man die magnetoresistiven Schichtstreifen durch eine Oxydationsschutzschicht abdeckt (US-A-4622613). Weitere Angaben zur Oxydationsschutzschicht sind in der angegebenen Literaturstelle nicht enthalten. Damit ist die vermittelte technische Lehre zur Realisierung der beschriebenen Sensoranordnung einschließlich der Funktion der Schutzschicht nicht ausreichend. Die Schutzschicht müßte einander widersprechende Eigenschaft aufweisen. Da der Oxydationsschutz nur von einer Schicht einer bestimmten Mindestdicke gewährleistet werden kann, wird es im Falle einer isolierenden Schicht unmöglich, die Leitschichtstreifen niederohmig an den magnetoresistiven Schichtstreifen anzukoppeln. Damit wird ihre beabsichtigte Wirkung als Äquipotentiallinie des elektrischen Feldes im magnetoresistiven Schichtstreifen aufgehoben oder zumindest soweit vermindert, daß die Sensor empfindlichkeit sehr stark beeinträchtigt wird. Im Falle einer leitfähigen Schutzschicht stellt die Ankopplung der Leitschichtstreifen kein Problem dar. Jedoch wird wegen der erforderlichen Mindestdicke dann ein wesentlicher Teil des Stromes, der eigentlich durch die magnetoresistive Schicht fließen sollte, in der Schutzschicht fließen. Da sich deren Widerstand natürlich im angelegten Magnetfeld nicht ändert, wird auch hier ein wesentlicher Empfindlichkeitsabfall des Sensors die Folge sein. Naheliegend wäre die Strukturierung der Schutzschicht etwa in der Art, daß dieselbe an den Stellen, an denen später die Leitschichtstreifen aufgebracht werden sollen, entfernt wird. Das hat neben der erheblichen Schwierigkeit bei den erforderlichen großen Genauigkeitsanforderungen, die aus den geringen Abmessungen der Strukturen im Mikrometerbereich resultieren, auch noch den Nachteil, daß die Oberfläche der magnetoresistiven Schicht im Strukturierungsprozeß verunreinigt wird und damit die Ankontaktierung der Leitschichtstreifen auch nicht ohne weiteres möglich ist.

Der Erfindung liegt nun die Aufgabe zugrunde, den bekannten magnetoresistiven Sensor mit Schutzschicht so auszugestalten und weiterzubilden, daß sich auch im Bereich höherer Einsatztemperaturen keine bleibenden Änderungen der funktionsbestimmenden Eigenschaften der magnetoresistiven Schicht wie erhöhte Hysterese oder absinkende Änderung des Widerstandes im Magnetfeld ergeben, daß die Empfindlichkeit des Magnetfeldnachweises nicht durch das Vorhandensein der Schutzschicht abgesenkt ist und daß keine zusätzlichen hochpräzisen, aufwendigen Strukturierungsschritte erforderlich sind.

Die zuvor aufgezeigte Aufgabe ist bei einem magnetoresistiven Sensor mit den Merkmalen des Oberbegriffs von Anspruch 1 durch die Merkmale des kennzeichnenden Teils von Anspruch 1 gelöst. Die in der Formel angegebenen Oxi- bzw. Karbonitride sind metallisch leitend. Die Leitfähigkeit der Materialien kann in weiten Grenzen durch den Anteil an Sauerstoff bzw. Kohlenstoff, also durch die Größe des x-Wertes, beeinflußt werden. Mit steigendem x sinkt die Leitfähigkeit ab. Bei Schichtdicken, die für den Schutz der magnetoresistiven Schicht vor Oxydation ausreichend sind, wird ein so guter elektrischer Kontakt zwischen der magnetoresistiven Schicht und den Leitschichtstreifen gewährleistet, daß dadurch kein Ausgangssignalabfall auftritt. Dazu ist es jedoch zweckmäßig, daß mindestens die erste Einzelschicht in der Herstellung unmittelbar und ohne Vakuumunterbrechung auf die magnetoresistive Schicht aufgebracht wird oder daß die Oberfläche der magnetoresistiven Schicht mit Hilfe eines Abtrageverfahrens im Vakuum gereinigt worden ist. Durch die wegen des notwendigen Oxydationsschutzes vorgegebene Mindestdicke der Schutzschicht sowie vorzugsweise auch die über den x-Wert eingestellte Leitfähigkeit wird erreicht, daß die elektrisch parallel zur magnetoresistiven Schicht geschaltete Schutzschicht in ihrer Hauptebene immer noch einen so hohen Widerstand hat, daß nur ein völlig unerheblicher Stromanteil durch diese fließt. Damit ist auch hier ein möglicher Ausgangssignalabfall verhindert.

Die aus dem angegebenen Material bestehende Schutzschicht verhindert nicht nur das Eindringen von Sauerstoff aus der Atmosphäre oder aus den in weiteren Bearbeitungsschichten verwendeten Medien in die magnetoresistive Schicht, sondern stellt auch eine Barriere für das Eindringen des Leitschichtmaterials in die magnetoresistive Schicht dar. Als Leitschichtmaterial kommt vorzugsweise Aluminium zum Einsatz. In der magnetoresistiven Schicht vorhandenes Aluminium verringert die Größe der Widerstandsänderung im Magnetfeld und vergrößert die Hysterese der Widerstands- /Magnetfeldkurve. Die Schutzschicht der erfindungsgemäßen Zusammensetzung verhindert das Eindringen von Aluminium. Von praktischer Bedeutung ist dies insbesondere bei höheren Einsatztemperaturen, da es gerade hier darauf ankommt, die sonst starken Diffusionsvorgänge von der Aluminium-Leitschicht in die magnetoresistive Schicht zu unterbinden.

Ohne die erfindungsgemäß zusammengesetzte Schutzschicht ist die Strukturierung der Leitschichten nur im Lift-off-Verfahren möglich. Schutzschichten der erfindungsgemäßen Zusammensetzung sind jedoch in der Lage, die magnetoresistiven Schichten vor den zur Ätzstrukturierung der Leitschichten eingesetzten Mitteln zu schützen. So werden starke Einschränkungen in den Bearbeitungsmöglichkeiten der Leitschichten aufgehoben und die Integration von magnetoresistiven Sensoren mit Halbleiteransteuer- und Auswerteschaltungen wird damit auf einen technisch realisierbaren Stand gebracht. Zur Anwendung der Ätzstrukturierung der Leitschichten ist es allerdings nötig, die magnetoresistiven Schichtstreifen von allen Seiten mit Schutzschichten zu bedecken. Vorteilhafterweise wird deshalb die magnetoresistive Schicht sofort nach ihrer Abscheidung mit einer ersten Einzelschicht abgedeckt. Danach werden die magnetoresistiven Schichtstreifen strukturiert. Es ist klar, daß die seitlichen Flächen der Streifen dann zunächst nicht abgedeckt sind. Deshalb wird in einem weiteren Arbeitsschritt eine zweite Einzelschicht gleicher oder unterschiedlicher Zusammensetzung und Dicke aufgetragen und danach mit größerer Breite so strukturiert, daß nun auch die seitlichen Flächen der magnetoresistiven Schichtstreifen abgedeckt sind. Bei der Anwendung einer aus mehreren Einzelschichten bestehenden Schutzschicht ist das Einhalten des erforderlichen großen Verhältnisses zwischen dem Widerstand der parallel zur magnetoresistiven Schicht geschalteten Schutzschichtabschnitte und dem Übergangswiderstand zwischen magnetoresistiver Schicht und Leitschicht nicht ohne weiteres möglich. Deshalb ist insbesondere hier erfindungsgemäß der Anteil x des Sauerstoffes bzw. Kohlenstoffes im Material der Einzelschichten in den Bereichen, die nicht von den Leitschichtstreifen abgedeckt sind, höher eingestellt als er unter den Leitschichtstreifen ist. Das kann in der Fertigung nach der Strukturierung der Leitschichtstreifen einfach z. B. durch Implantieren von Sauerstoff bzw. Kohlenstoff nach bekannten Verfahren geschehen. Dazu sind keine zusätzlichen Maskierungsschritte erforderlich, da die Schutzschichtbereiche unter den Leitschichtstreifen bei der Implantation durch dieselben abgedeckt sind. Da die Leitfähigkeit des erfindungsgemäßen Schutzschichtmaterials mit steigendem Sauerstoff- bzw. Kohlenstoffgehalt abnimmt, ist der entsprechende Parallelwiderstand ohne weiteres auf einen genügend hohen Wert einstellbar.

Die Erfindung wird nun nachfolgend anhand einer lediglich ein Ausführungsbeispiel darstellenden Zeichnung näher erläutert. In der Zeichnung zeigt
- Fig. 1: in einer Draufsicht einen Ausschnitt eines erfindungsgemäßen magnetoresistiven Sensors und
- Fig. 2: einen Querschnitt durch den Sensor aus Fig. 1 entlang der Linie II-II.

Die in der Zeichnung gegebene Darstellung ist nicht maßstabsgetreu, damit das Prinzip des erfindungsgemäßen magnetoresistiven Sensors richtig verstanden werden kann. Insbesondere sind der Deutlichkeit halber alle Schichtdicken im Verhältnis zu den Schichtbreiten zu groß und auch im Verhältnis zueinander nicht maßstäblich dargestellt.

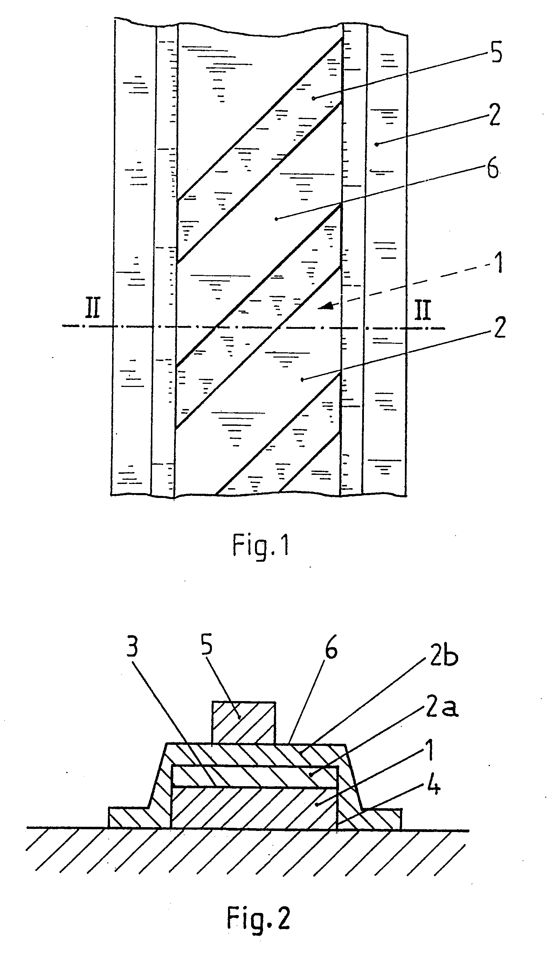

Der erfindungsgemäße magnetoresistive Sensor kann in besonders zweckmäßiger Weise als Wheatstone-Brücke aus vier Brückenwiderständen aufgebaut sein, wobei Fig. 1 und Fig. 2 einen dieser Brückenwiderstände darstellen. Fig. 1 und Fig. 2 zeigen zunächst einen magnetoresistiven Schichtstreifen 1 auf einem nicht mit einem Bezugszeichen versehenen Träger, normalerweise einem Träger aus einem gut wärmeleitenden, elektrisch isolierenden Material.

Direkt auf dem magnetoresistiven Schichtstreifen 1 aus Permalloy von etwa 10 µm Dicke ist im gleichen Herstellungsschritt ohne Vakuumunterbrechung eine erste Einzelschicht 2a, die aus Nb N₍₁₋ₓ₎Oₓ besteht, und die eine Dicke von 6 µm hat, aufgebracht. Der Sauerstoffanteil des Materials wird durch den Parameter x = 0,03 charkterisiert. Da die Einzelschicht 2a metallisch leitet und unmittelbar nach dem magnetoresistiven Schichtstreifen 1 aufgebracht ist, wird der elektrische Kontakt zwischen beiden nicht durch eine verunreinigte, insbesondere oxydierte Oberfläche gestört. Zur Herstellung des magnetoresistiven Schichtstreifens 1 mit der ersten Einzelschicht 2a von etwa 10 µm Breite wird die Fotoätztechnik angewendet. Es entstehen so Schichtstreifen 1, deren obere Fläche 3 abgedeckt ist, während die seitlichen Fläche 4 freibleiben. Um auch die seitlichen Flächen 4 abzudecken, wird in einem weiteren Herstellungsschritt eine zweite Einzelschicht 2b mit gleicher Zusammensetzung und Dicke wie oben angegeben, aufgetragen. Sie wird so strukturiert, daß sie eine größere Breite hat als der magnetoresistive Schichtstreifen 1. Damit ist dieser vollständig durch die Einzelschichten 2a, b abgedeckt. Auf diese Schutzschicht 2 sind Leitschichtstreifen 5 aus Aluminium mit einer Dicke von 0,6 µm abgeschieden. Die bei der Strukturierung der Leitschichtstreifen 5 mit einer Breite von 3 µm in Fotoätzverfahren eingesetzten Ätzmittel können durch die Wirkung der Schutzschicht 2 die magnetoresistiven Schichtstreifen 1 nicht angreifen. Wegen der guten metallischen Leitfähigkeit und der geringen Dicke der Einzelschichten 2a, b sind die Leitschichtstreifen 5 sehr niederohmig mit den magnetoresistiven Schichtstreifen 1 kontaktiert. Dadurch und durch den geringen Widerstand der Leitschichtstreifen 5 steht die Richtung des Stromes durch die magnetoresistiven Schichtstreifen 1 bei Betrieb des Sensors im wesentlichen senkrecht zur Richtung der Leitschichtstreifen 5, und es werden Ausgangssignalverluste des Sensors vermieden. Damit der Widerstand der beiden Einzelschichten 2a, b im Bereich 6, der nicht von den Leitschichtstreifen 5 abgedeckt sind und elektrisch parallel zum Widerstand des magnetoresistiven Schichtstreifens 1 geschaltet ist, gegenüber diesem einen sehr großen Wert annimmt, ist in die beiden Einzelschichten 2a, b in einem weiteren Herstellungsschritt Sauerstoff implantiert. Damit ist hier ein durch x = 0,17 charakterisierter Sauerstoffanteil erreicht. Der spezifische Widerstand des Materials der Einzelschichten 2a, b ist hier mehr als fünf Mal höher als in den Bereichen unter den Leitschichtstreifen 5. Diese Bereiche bleiben durch die Abschirmwirkung der Leitschichtstreifen 5 selbst bei der Implantation von zusätzlichem Sauerstoff frei. Deshalb sind auch bei der Implantation keine hochpräzisen Maskierungsschritte im Abmessungsbereich von wenigen Mikrometern erforderlich.

Die beiden Einzelschichten 2a, b aus dem angegebenem Material stellen in den Bereichen 6, die nicht von den Leitschichtstreifen 5 abgedeckt sind, eine Barriere für die Diffusion des Sauerstoffes aus der Atmosphäre und im Breich der Leitschichtstreifen 5 für die Diffusion des Aluminiums dar. Die Barrierenfunktion der Einzelschichten 2a, b ist bis zu Temperaturen von etwa 300 °C gegeben und schließt in diesem, gegenüber ungeschützten magnetoresistiven Schichten bedeutend erweiterten Arbeitstemperaturbereich den schädlichen Einfluß von Sauerstoff und Aluminium aus. Dieser würde in einer mit zunehmender Betriebsdauer abnehmenden Widerstandsänderung der magnetoresistiven Schichten im Magnetfeld und in zunehmender Hysterese in der Widerstands-Magnetfeldkurve bestehen. Durch die erfindungsgemäße Schutzschicht 2 wird also die Stabilität und Zuverlässigkeit der Sensoren wesentlich erhöht.

## Patentansprüche

1. Magnetoresistiver Sensor mit mindestens einem magnetoresistiven Schichtstreifen (1) auf einem Träger, einer den Schichtstreifen (1) bedeckenden Schutzschicht (2) und unter bestimmten Winkeln und in bestimmten Abständen auf der Schutzschicht (2) angeordneten Leitschichtstreifen (5), **dadurch gekennzeichnet,** daß die Schutzschicht (2) aus einem Material der Zusammensetzung MN₍₁₋ₓ₎Aₓ besteht, wobei M eines der Metalle Hf, Nb, Ta, Ti oder Zr und A Sauerstoff und/oder Kohlenstoff ist und x im Bereich von 0 bis 0,5, vorzugsweise von 0 bis 0,2, insbesondere von 0,01 bis 0,2 liegt.

2. Magnetoresistiver Sensor nach Anspruch 1, dadurch gekennzeichnet, daß die Schutzschicht (2) aus mehreren, insbesondere zwei gleichen oder unterschiedlichen, mindestens teilweise übereinanderliegenden Einzelschichten (2a, 2b) aufgebaut ist und beide Einzelschichten (2a, 2b) aus einem Material der Zusammensetzung gemäß Anspruch 1 bestehen.

3. Magnetoresistiver Sensor nach Anspruch 1 oder 2, dadurch gekennzeichnet, daß sich eine erste Einzelschicht (2a) lediglich auf der vom Träger wegweisenden Oberfläche (3) des magnetoresistiven Schichtstreifens (1) befindet, dessen seitliche Flächen (4) jedoch frei läßt und daß eine zweite Einzelschicht (2b) auf der ersten Einzelschicht (2a) und mindestens auch auf den seitlichen Fläche (4) des Schichtstreifens (1) angeordnet ist.

4. Magnetoresistiver Sensor nach einem der Ansprüche 1 bis 3, dadurch gekennzeichnet, daß der Anteil des Stoffes A im Material der Schutzschicht (2) bzw. mindestens einer der Einzelschichten (2a, 2b) der Schutzschicht (2) in Bereichen (6), die nicht von den Leitschichtstreifen (5) abgedeckt sind, höher ist als in unter den Leitschichtstreifen (5) liegenden Bereichen.

5. Magnetoresistiver Sensor nach einem der Ansprüche 1 bis 4, dadurch gekennzeichnet, daß mehrere, insbesondere vier von einer entsprechenden Schutzschicht (2) bedeckte Schichtstreifen (1) mit entsprechenden Leitschichtstreifen (5) in einer Brückenschaltung zusammengeschaltet sind.

## Claims

1. A magnetoresistive sensor with at least one magnetoresistive coating strip (1) on a support, a protective film (2) covering the coating strip (1) and conductive coating strips (5) disposed on the protective film (2) at definite angles and at definite spacings, characterised in that the protective film (2) consists of a material of composition MN₍₁₋ₓ₎Aₓ, where M is one of the metals Hf, Nb, Ta, Ti or Zr, A is oxygen and/or carbon, and x is in the range from 0 to 0,5, preferably from 0 to 0,2, most preferably from 0.01 to 0.2.

2. A magnetoresistive sensor according to claim 1, characterised in that the protective film (2) is built up from a plurality of individual films (2a, 2b) which are at least partially superimposed and which are the same or different, particularly from two such films, and both individual films (2a, 2b) consist of a material with the composition according to claim 1.

3. A magnetoresistive sensor according to claim 1 or 2, characterised in that a first individual film (2a) is only located on the surface (3) of the magnetoresistive coating strip (1) facing away from the support, leaving the side faces (4) of the magnetoresistive coating strip exposed, however, and that a second individual film (2b) is disposed on the first individual film (2a) and also at least on the side face (4) of the coating strip (1).

4. A magnetoresistive sensor according to any one of claims 1 to 3, characterised in that the content of component A in the material of the protective film (2) or in at least one of the individual films (2a, 2b) of the protective film (2) is higher in regions (6) which are not masked by the conductive coating strips (5) than it is in regions lying underneath the conductive coating strips (5).

5. A magnetoresistive sensor according to any one of claims 1 to 4, characterised in that a plurality of coating strips (1) covered by a corresponding protective film (2), particularly four such coating strips, are connected together in a bridge circuit by means of corresponding conductive coating strips (5).

## Revendications

1. Détecteur magnétorésistif, comprenant au moins une bande de couche magnétorésistive (1) sur un support, une couche de protection (2) recouvrant la bande de couche (1), et des bandes de couches conductrices (5) disposées sur la couche de protection (2) sous des angles déterminés et à des intervalles déterminés, **caractérisé par le fait** que la couche de protection (2) est constituée d'un matériau de la composition MN₍₁₋ₓ₎Aₓ, M étant l'un des métaux Hf, Nb, Ta, Ti ou Zr et A étant de l'oxygène et/ou du carbone, et x se situant à l'intérieur de la plage de 0 à 0,5, de préférence de 0 à 0,2 et notamment de 0,01 à 0,2.

2. Détecteur magnétorésistif selon la revendication 1, caractérisé par le fait que la couche de protection (2) est composée de plusieurs, en particulier de deux couches individuelles (2a, 2b) identiques ou différentes partiellement superposées, et que les deux couches individuelles (2a, 2b) sont constituées d'un matériau de la composition selon la revendication 1.

3. Détecteur magnétorésistif selon l'une des revendications 1 ou 2, caractérisé par le fait qu'une première couche individuelle (2a) se trouve seulement sur la surface (3) de la bande de couche magnétorésistive (1) détournée du support dont elle laisse cependant dégagées les surfaces latérales (4), et qu'une seconde couche individuelle (2b) est disposée sur la première couche individuelle (2a) et au moins aussi sur les surfaces latérales (4) de la bande de couche (1).

4. Détecteur magnétorésistif selon l'une des reven- dications 1 à 3, caractérisé par le fait que la proportion de la substance A dans le matériau de la couche de protection (2) et respectivement dans au moins l'une des couches individuelles (2a, 2b) de la couche de protection (2) est plus grande dans les zones couche non recouvertes par les bandes de couches conductrices (5) que dans des zones situées sous les bandes de couches conductrices (5).

5. Détecteur magnétorésistif selon l'une des revendications 1 à 4, caractérisé par le fait que plusieurs, en particulier quatre bandes de couches (1) recouvertes par une couche de protection (2) correspondante sont montées en pont avec des bandes de couches conductrices (5) correspondantes.
